# EUROPEAN PATENT APPLICATION

(11) **EP 2 175 704 A1**
(43) Date of publication of application: **14.04.2010**
(21) Application number: 08166206.6
(22) Date of filing: 09.10.2008
(51) Int. Cl.: H05K 3/32, H01R 12/04, H05K 3/36, H05K 3/40

(54) **An arrangement for electrically and mechanically connecting electronic components to each other**

(71) Applicant: 3M Innovative Properties Company, St. Paul, MN 55133-1000 (US)
(72) Inventor: Van Meijl, Frank, 5712 NK Someren-Eind (NL); Brandt, Konrad, 22880 Wedel (DE); Ploehn, Guenther, 23689 Techau (DE)
(74) Representative: Bergen, Katja

(57) **Abstract**

The invention relates to an arrangement for electrically and mechanically connecting electronic components to each other comprising a first part 1 and second part 22, the two parts each comprise a mechanical reclosable fastener component 11 configured to mate with the mechanical reclosable fastener component 11 of the other part, the fastener components 11 are having a first side 3 providing fastening elements 2 for making a mechanical connection and a second side 4, wherein the first side 3 of the fastener components 11 provides a surface that is made out of an electrically conductive material 5 for making an electrical connection and wherein a conductive path 6, 13 is provided that electrically connects the first side 3 with the second side 4 of the reclosable fastener components 11.

## Description

### Technical Field

The invention relates to an arrangement for electrically and mechanically connecting electronic components to each other.

### Background Art

DD 262 316 A1 discloses an arrangement for electrically connecting electronic components to each other, such as printed circuit boards or the like, using electrically conductive wire meshes as a connector. A first wire mesh comprises hooks and a second wire mesh comprises loops. The wire meshes are used as a mechanical reclosable fastener that mechanically and electrically connects the electronic components to each other. The wire meshes may comprise conductive and non conductive areas. The wire meshes may be attached to the electronic components by soldering or gluing with conductive adhesive.

EP 1 245 933 A2 describes an electro-mechanical device for mounting an electronic component group on a support, especially for mounting an instrument display in an instrument panel or dashboard. The support described in this document does not have any electric or electronic features. The device comprises a connector that is made out of an electrically conducting material in the shape of a hook-and-loop-fastener or a VELCRO ® fastener that serves for a mechanical fastening and an electrical connection. The fastener may be made out of a conductive material or a material that is coated with a conductive material. It is also disclosed to use several fasteners for several conductive paths.

US 5,774,341 describes a solderless electrical interconnection for electronic components with a substrate and electrically conductive pathways on the substrate. Electrically conductive hook fasteners are embedded in the substrate. The upper part of the fastener is exposed in the top side of the substrate, the central part is embedded within the substrate itself and the lower or hook portion of the fastener protrudes from the bottom side of the substrate. The electrically conductive pathways defined on the top side of the substrate make contact with the exposed upper part of the hook fastener. The hook fastener is engaged to electrically conductive loop fasteners on a second substrate in order to create a solderless interconnection and mechanical interlocking between two substrates. Provision for the loop fasteners is made either by selectively depositing discrete portions of the loop material on the desired pads of the substrate or a larger piece of the loop fastener material may be disposed over a plurality of contact pads on the printed circuit board and desired areas selectively metallised in order to add conductivity to selected portions of the loop fasteners.

A conductive hook-and-loop fastener is also described in JP 2003-299 506 A.

WO 2005/025362 A1 describes a connector for electrically connecting electronic components to each other comprising a hook-and-loop type of a mechanical reclosable fastener made out of electrically conductive polymers or non conductive polymers coated with an electrically conductive material.

US 4,848,351 discloses a medical electrode assembly. The electrode comprises a conductive loop fastener that interacts with an electrically conductive hook fastener for electrically and mechanically connecting the electrode with a monitoring system.

There is a need for an arrangement for electrically and mechanically connecting electronic components to each other that provides a simplified connection and is therefore cheap and easy to handle as well. There is further a need for a simplified connector that, although frequently used, that means frequently mated and unmated, provides a reliable connection. Such a connector should further be easily adapted in versatile applications, such as for example when miniaturized in small applications or with big dimensions e.g. for high current applications.

### Summary of the Invention

The present invention provides an arrangement for electrically and mechanically connecting electronic components to each other comprising a first part and a second part the two parts each comprise a mechanical reclosable fastener component configured to mate with the mechanical reclosable fastener component of the other part, the fasteners are having a first side providing fastening elements for making a mechanical connection and a second side, wherein the first side of the fastener components provides a surface that is at least partially made out of an electrically conductive material for making an electrical connection and wherein a conductive path is provided that electrically connects the first side with the second side of the reclosable fastener component. The first and the second side may be arranged on opposite sides of the mechanical reclosable fastener or on adjacent sides.

The present invention may provide an arrangement for electrically and mechanically connecting electronic components to each other comprising a first part and a second part the two parts each comprise a mechanical reclosable fastener component configured to mate with the mechanical reclosable fastener component of the other part, the fasteners may be made out of an insulating material and may have a first side providing fastening elements for making a mechanical connection and a second side, wherein the first side of the fastener components is at least partially coated with an electrically conductive material for making an electrical connection and wherein a conductive path is provided that electrically connects the first side with the second side of the reclosable fastener component. It is also possible to make at least one of the two parts out of an electrically conductive material. In that case the conductive path goes directly through the part itself.

The arrangement for electrically and mechanically connecting electronic components according to an aspect of the invention comprises at least two parts a first part and a second part. The arrangement according to an aspect of the invention may be a connector with for example a male part and a female part. The two parts of the arrangement are designed in such a way that they fit to each other. Therefore the two parts comprise mechanical reclosable fastener components mating with each other. The first and the second part may consist of a mechanical reclosable fastener component or they may comprise other components beside the mechanical reclosable fastener components. In other words, the two parts of the arrangement according to the invention can be attached to each other thereby creating a mechanical connection between the two. The mechanical connection created between the two parts is reclosable, which means that it can be opened and closed several times. Mechanical reclosable fasteners are fasteners that provide a reclosable mechanical bond. The reclosable fastener components may be of all kind of shapes, such as hook-and-loop type of reclosable fasteners, hook-and-hook type of reclosable fasteners, which means that the fastening elements may have different or the same shape.

The reclosable fastener components may also have small and big dimensions. An example for a mechanical reclosable fastener with a smaller dimension is a height of 0,25 mm and an example of a bigger dimension is a height of 2,67 mm. The shape of the parts of the arrangement can be minimized and therefore be used in applications that need small dimensioned connectors such as for example connecting printed circuit boards to each other or the like. With such an application it is possible to replace soldering processes for example for backplanes. In such cases no excessive heat is needed to make the electrical connection and therefore standard engineering plastics can replace high temperature resistant materials. This makes the assembly of the printed circuit board less complicated and the total costs will decrease. Other possible applications may be high frequency applications, automotive and aerospace applications, consumer electronics as well as electronics integrated into clothing. By providing an arrangement with large dimensions the arrangement according to an aspect of the invention can be used for example for power contacts. In these applications the contact areas conducting the current through the arrangement and especially the surface conducting the current from one part of the arrangement to the other part is larger and therefore higher currents can be transmitted through the electrical interface.

The use of mechanical reclosable fastener components as an interconnection of electronic parts further has the advantage that depending on the dimensions or the mechanical reclosable fastener the conductive area is high because the number of contact points is large. Each pillar of the reclosable fastener may create an electrical contact spot and there may be a lot of pillars available per connection. Furthermore reparability of constructions, compared to soldered constructions, using the arrangement according to an aspect of the invention is very easy because reclosable fastener connections can be unmated and re-mated.

The arrangement according to an aspect of the invention or the connector according to an aspect of the invention further provides a conductive path that electrically connects the first side of the two parts that is coated with the electrically conductive material and a second side of the part. Thereby the arrangement provides the possibility of leading signals or an electric current from the fastening elements that may be made out of electrically conductive material or that may be coated with electrically conductive material to another side of the part of the arrangement and vice versa. The other side of the part of the arrangement may be attached to another electronic component, a wire or the like and is used for further transmitting the signal or current received by the connector or part with the mechanical reclosable fastener component. The second side may comprise a transmitting point for this transmission of current or signals. If the mechanical reclosable fastener is made out of an isolative material that is at least partially coated the conductive path may go along the surface of the mechanical reclosable fastener that is coated. If the mechanical reclosable fastener is made out of electrically conductive material the conductive path may go through the mechanical reclosable fastener component itself.

An arrangement according to an aspect of the invention provides the possibility of creating a gas tight connection and also sealing options can easily be integrated into the arrangement. For such an application the arrangement may provide insulating parts made out of insulating materials such as for example silicon or rubber. If the insulating parts also have the shape of the mechanical reclosable fastener as the first and the second part of the arrangement a very simple sealed connection can be established.

Combining the mechanical properties of a mechanical reclosable fastener with electrical properties of an adequate coating opens a wide range of applications. For example assemblies can be simplified by directly achieving the electrical interconnection during the mechanical fixing process. Furthermore the mechanical reclosable fastener may be flexible thereby providing the possibility of electrical interconnections on 3D structures for example for 3D moulded interconnect device applications, applications in automobiles or aeroplanes etc..

The arrangement according to an aspect of the invention may be used as a single electrical connection such as for example for connecting two printed circuit boards to each other. In such an application the first side of the two parts or the two mechanical reclosable fastener components of the arrangement according to an aspect of the invention needs to have an overall surface out of an electrically conductive material. The conductive path may be provided by coating the edges of the two mechanical reclosable fastener components as well or by coating the mechanical reclosable fastener components overall thereby providing the possibility of transporting the current or signal from the first side with the fastening elements to the bottom side of the reclosable fastener component that is attached to the printed circuit board. Another possibility would be to have a mechanical reclosable fastener that is made out of an electrically conductive material. In that case the conductive path would go through the fastener component. Pressing the two parts with the mechanical reclosable fastener components onto each other creates a mechanical bond and an electrical connection. For providing a mechanical and an electrical connection between each of the two fastener components of the arrangement according to an aspect of the invention and the two printed circuit boards the two fastener components may be glued with an electrically conductive adhesive, soldered or welded to the printed circuit boards.

The arrangement according to an aspect of the invention may have two mechanical reclosable fastener components, one for each of the two parts, each fastener component providing the same geometrical shape. Such mechanical reclosable fasteners are called self fastening or hermaphroditic mechanical reclosable fasteners. Self fastening reclosable fastener elements may have the shape of hooks especially the shape of mushrooms with shanks and heads. Those mushroom shaped hook fastener elements have the advantage that they can easily be manufactured for example by continuous mould injection or continuous casting and that they provide strong tensile and shear strength.

The fastening elements of the two mechanical reclosable fastener components may all have the same height or they may have different heights. Having for example an arrangement according to one aspect of the invention with a first part with fastening elements with the same height and a second part with fastening elements with at least two different heights would have the advantage of reducing the mating and unmating forces because mating and unmating would be possible in more than one step. This is because during the mating or unmating operation the highest pins (e.g. power) would first mate with the corresponding fastener component and then the lower pins (e.g. signal) would engage.

Instead of having several mushroom shaped fastening elements it is also possible to have lines of fastening elements each line having a shank portion and a head portion and the shank portion and/or the head portion being partially coated with electrically conductive material. It is possible to have such design on only one part of an arrangement according to the invention or on both parts of the arrangement according to the invention.

According to another aspect of the invention the arrangement with the two parts comprising mechanical reclosable fastener components may provide conductive or non-conductive areas on the first side thereby creating the possibility of separate individual interconnections. By this configuration of the two parts of the arrangement it is possible to transmit more than one signal from one part of the arrangement to the other part. It is possible to build the non-conductive areas either by not coating them with electrically conductive material that means by selectively plating the mechanical reclosable fastener component. It is also possible to build them by completely coating the mechanical reclosable fastener component and than eliminating the fastening elements or the coating of these of the mechanical reclosable fastener components in the non conductive areas for example by drilling, milling or by laser cutting them. With such an embodiment of the invention it is possible to design one and two row connectors for transmitting more than one signal from one part of the arrangement to the other. In these applications a conductive path for transmitting a current from the first side with the fastening elements to the second side is necessary as well and may be realised by coating the edges of the mechanical reclosable fastener thereby connecting the conductive areas from the first side with conductive areas on the second side of the mechanical reclosable fastener components.

The mechanical reclosable fastener components may be made out of an insulating material and at least partially coated with an electrically conductive material. The insulating material may be for example plastic e.g. polypropylene, polyester, nylon etc.. Using plastic has the advantage that the mechanical reclosable fasteners can be produced easily by for example injection moulding or casting or extrusion. In order to establish an electrical connection on top of the mechanical connection the mechanical reclosable fastener components of the two parts of the arrangement according to the invention may be coated with an electrically conductive material, such as for example steel, nickel, silver, gold, tin, palladium, copper and various alloys of these materials. The coating is at least provided on parts of the first side of the fastener component comprising the fastening elements and on the conductive path. Thereby the mechanical reclosable fastener components of the arrangement of the invention establish both the mechanical and the electrical connection. It is also possible to have at least one part with a mechanical reclosable fastener component made out of electrically conductive material. If the first part is made out of insulating material coated with an electrically conductive coating and the second part is made for example out of metal, the first part could be a female part of an interconnection and the second part could be a male part. A mechanical reclosable fastener made out of electrically conductive material can be extruded or made by means of die casting as well.

According to a further embodiment of the arrangement according to an aspect of the invention the mechanical reclosable fastener components may provide edges and/or holes or micro-vias coated with electrically conductive material as conductive paths. Having a single electrical connection the current received at the first side with the fastening elements of the mechanical reclosable fastener component may be transmitted to other parts of the arrangement e.g. to a second side of the mechanical reclosable fastener component over coated edges. In such a configuration the current received at the fastening elements from the first side flows along the fastening element itself along the bottom of the first side of the mechanical reclosable fastener component to its edge and then along the edge to the other side. Such a guiding path or conductive path can be used for single connectors as well as for one and two row connections where every individual interconnection provides an edge that can be coated and thereby be used as a conductive path. For matrix connection with a plurality of individual interconnections - some of them not having an edge - coated holes or coated micro vias in the mechanical reclosable fastener component may be provided. In such a configuration the current received at the fastening elements flows along the fastening elements from the first side along the bottom of the first side of the mechanical reclosable fastener component to a coated hole or micro-via then to the other side. In other words through holes may be part of the mechanical reclosable fastener component or interconnection component and may electrically connect two sides of the component with each other. If the mechanical reclosable fastener component of at least one part of the arrangement is made out of an electrically conductive material the conductive path lies within the mechanical reclosable fastener component, in other words the signal or electric current goes through the component.

To provide an arrangement according to the invention with a special protection for example a protection against influences of the environment or short circuits some head portions of the fastening elements of at least one part of the arrangement may be non conductive. In other words no access is possible to open electrical contacts with for example fingers or tools. Especially when the arrangement according to the invention is used as connectors in a network or telecommunication environment a short circuit protection may be a very important feature.

One possible embodiment according to this aspect of the invention may be a self fastening reclosable fastener with a first part that is overall coated or plated with an electrical conductive coating or that is made out of an electrically conductive material. This part may function as a male connector such as contact elements in an open housing. The second part may also be overall coated with an electrical conductive coating or may be made out of an electrically conductive material but additionally an insulating material may cover the tips or the heads of the mechanical reclosable fastener. In other words at least some head portions of the fastening elements of at least one part are non conductive. This part may function as a female part of a connector with hidden contact elements. The insulating material can be put on by means of a dip process, by painting, by spraying or the like. When the self fastening reclosable fastener has mushroom shaped stems the electrical connection between the two mechanical reclosable fastener components may be created on the electrical stem under the head of the stems.

According to a further embodiment of the invention the second side of the mechanical reclosable fastener components may provide fastening elements as well. The fastening elements of the two sides may have different shapes and/or dimensions or they may be of the same shape and dimension. One shape may for example be optimized to make a mechanical and/or electrical connection with a hole in a printed circuit board, while the other side may be used for example to connect to another mechanical reclosable fastener component. The freedom of design can be used to optimize the mechanical and/or electrical requirements per side. For example the connection to the printed circuit board can be a permanent interconnection or a connection with infrequent mating cycles, while the other side can be used to frequently change sensors or the like.

The invention further comprises an arrangement for electrically and mechanically connecting electronic components to each other comprising a first part and a second part, the two parts each comprise a mechanical reclosable fastener component configured to mate with the mechanical reclosable fastener component of the other part, the fastener components are providing fastening elements for making a mechanical connection, wherein the fastening elements provide a surface that is at least partially made out of an electrically conductive material for making an electrical connection and wherein a conductive path is provided that electrically connects the coated fastening elements with a transmitting point.

A transmitting point is a point on the mechanical reclosable fastener component or a point on the part of the arrangement of the invention that transmits an electrical current or a signal from the reclosable fastener component or the part of the arrangement to an electronic component, a wire etc. that the arrangement connects. A signal or an electrical current that is received for example by an electrically conductive coated fastening element or a fastening element made out of electrically conductive material of the reclosable fastener component is guided along the stem of the fastening element to the bottom of the reclosable fastener component and from there into the conductive path to the transmitting point where it is transmitted to the other component. If a signal or an electrical current is received at the transmitting point it is guided along the conductive path to the bottom of the reclosable fastener component and from there over the stems of the fastening elements to their heads where it is passed over to the second part of the arrangement of the invention.

One application where the above described arrangement of the invention can be used is for example the connection of two or more printed circuit boards to each other or the connection of modules of printed circuit boards to each other. The design of printed circuit boards can be very complex, especially when higher signal frequencies are involved. Modifications are often time consuming, mostly limited and therefore very expensive. Due to the complexity of a multi-layer "all in one" design modifications may not fit into the current design of a printed circuit board. A complete new design has to be done. Splitting the design into several sections or modules could solve most of the problems. The individual sections or modules will be attached and will form a printed circuit board. Using an arrangement according to the invention as connector for these sections to build up a printed circuit board is very interesting since such connectors comprise a mechanical and an electrical interconnection.

For providing a possibility of flexible attaching printed circuit board or printed circuit board modules to each other the first and/or the second part of the arrangement is/are attached to a top side, a bottom side and/or an inner layer of a printed circuit board or printed circuit board module. The first and/or the second part of the arrangement may be attached by conductive adhesive, solder, welding and/or ultrasonic welding to the printed circuit board. The first and/or the second part of the arrangement according to the invention may also be attached by a mechanical reclosable fastener element to the printed circuit board as described above.

### Brief Description of the Drawings

The invention will now be described in more detail with reference to the following figures exemplifying particular embodiments of the invention:
- Fig. 1a: a schematic sectional view of one part of the arrangement according to an aspect of the invention with fastening elements on one side;
- Fig. 1b: a schematic sectional view of one part of the arrangement according to an aspect of the invention with fastening elements on two sides;
- Fig. 2: a schematic drawing of an arrangement according to an aspect of the invention for electrically and mechanically connecting two printed circuit boards to each other;
- Fig. 3: a three dimensional schematic drawing of a one row connector;
- Fig. 4: a three dimensional schematic drawing of a two row connector;
- Fig. 5: a three dimensional schematic drawing of a multiple two row connector;
- Fig. 6: a three dimensional schematic drawing of a matrix connector;
- Fig. 7a: a three dimensional schematic drawing of a part of a connector;
- Fig. 7b: a sectional view of the part of a connector shown in fig. 7a along the line A-A;
- Fig. 8: a schematic drawing of two fastening elements of a mechanical reclosable fastener;
- Fig. 9: a schematic drawing of two mating mechanical reclosable fasteners;
- Fig. 10: a schematic drawing of two printed circuit boards that are connected over an assembly according to the invention;
- Fig. 11: a three dimensional schematic drawing of the mechanical reclosable fastener component of the embodiment shown in Fig. 10;
- Fig. 12: a schematic drawing of two printed circuit boards that are connected over an assembly according to the invention;
- Fig. 13: a schematic drawing of a printed circuit board in a frame where the grounding is realised with an assembly according to the invention;
- Fig. 14: another embodiment according to the assembly of the invention for connection two printed circuit boards to each other;
- Fig. 15: a schematic drawing of another embodiment according to the assembly of the invention with fastening elements with two alternating heights;
- Fig. 16: a three dimensional drawing of another embodiment according to the assembly of the invention with an extruded mechanical reclosable fastener;
- Fig. 17: a schematic drawing of the embodiment according to the assembly of the invention shown in fig. 16 and
- Fig. 18: a three dimensional drawing of another embodiment according to the assembly of the invention with an extruded mechanical reclosable fastener.

### Description of Embodiments

Herein below various embodiments of the present invention are described and shown in the drawings wherein like elements are provided with the same reference numbers.

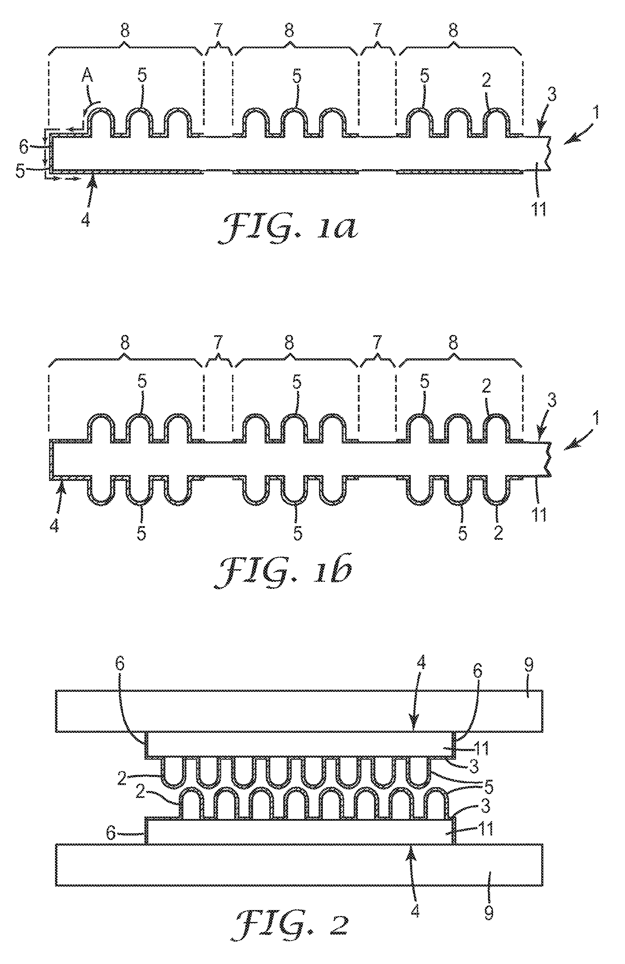

Fig. 1a shows a first part 1 of an arrangement for electrically and mechanically connecting electronic components to each other according to an aspect of the invention. The part 1 comprises a mechanical reclosable fastener component 11 with fastening elements 2 for making a mechanical connection with a second part or component of the arrangement (not shown in fig. 1a). The fastening elements 2 are all arranged on a first side 3 of the first part 1. The first part 1 also comprises a second side 4 that lies opposite of the first side 3. The first side 3 of the first part 1 with the fastening elements 2 is partially coated with an electrically conductive material 5 for making an electrical connection with the second part. The left edge 6 of the first part 1 is coated as well with the electrically conductive material 5. This coated edge 6 provides a conductive path from the first side 3 to the second side 4 of the first part 1. An electrical current or signal that is received from a fastening element 2 of the part 1 travels from the fastening element 2 to the coated bottom of the first side 3 of the first part 1 and from there around the edge 6 from the first side 3 to the second side 4 as indicated by the arrows A.

It is also possible to have fastening elements 2 on more than one side of the mechanical reclosable fastener component 11 as shown in Fig. 1b. The fastening elements 2 on the two sides may have the same shape and/or dimension as it is shown in fig. 1b. They may also have different shapes and/or dimensions.

The first part shown in fig. 1a provides non conductive areas 7. To establish these non conductive areas the fastening elements 2 may be eliminated and "flat zones" are created. In these flat zones that may be not coated with electrically conductive material or where the electrically conductive material has been removed no electrical interconnection with a second part is possible and therefore no transmission of an electric current or signal is possible. By providing several non conductive areas 7 between conductive areas 8 separate individual interconnections may be established. Such an arrangement may transmit several different signals over each individual interconnection. Another possibility for creating insulation zones or non conductive areas 7 is to have a mechanical reclosable fastener component 11 with fastening elements 2 equally disposed on one side. Individual conductive areas 8 can be created by selectively coating areas of the mechanical reclosable fastener component 11. Thereby non conductive areas 7 are created between the coated areas.

Fig. 2 shows a single electrical connection between two printed circuit boards 9. To each printed circuit board 9 a mechanical reclosable fastener component 11 with fastening elements 2 at its first side 3 is attached. The two mechanical reclosable fastener components 11 are overall coated with an electrically conductive material 5 - that means that the first side 3, the second side 4 - which is opposite of the first side - and the edges 6 are coated. It is also possible to have a mechanical reclosable fastener component made out of electrically conductive material and it is possible to have a mechanical reclosable fastener component that is only partially coated. When the two mechanical reclosable fasteners 11 are pressed onto each other a mechanical bond as well as an electrical connection is established between them. For providing the mechanical and electrical interconnection between the reclosable fastener components 11 and the printed circuit board 9 electrically conductive adhesive, soldering, welding and/or ultrasonic welding as well as further fastening elements of a mechanical reclosable fastener component can be used. An electrical current or a signal that has to be transmitted from one printed circuit board 9 to another printed circuit board 9 will be transported from the first side 3 to the second side 4 of the mechanical reclosable fastener 11 over a conductive path. The conductive paths in this embodiment are plated or coated edges 6. Instead of printed circuit boards, 3D moulded interconnect device substrates or wires may be connected by the arrangement according to the invention as well.

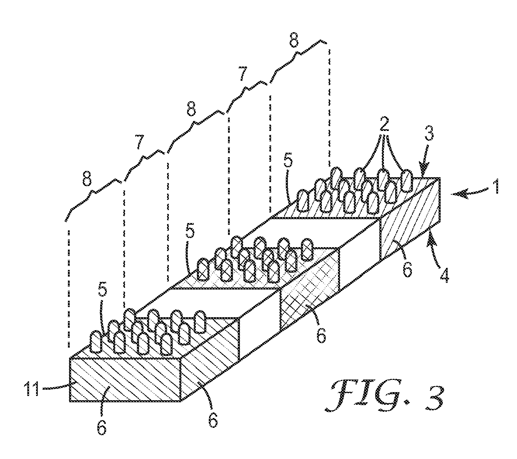

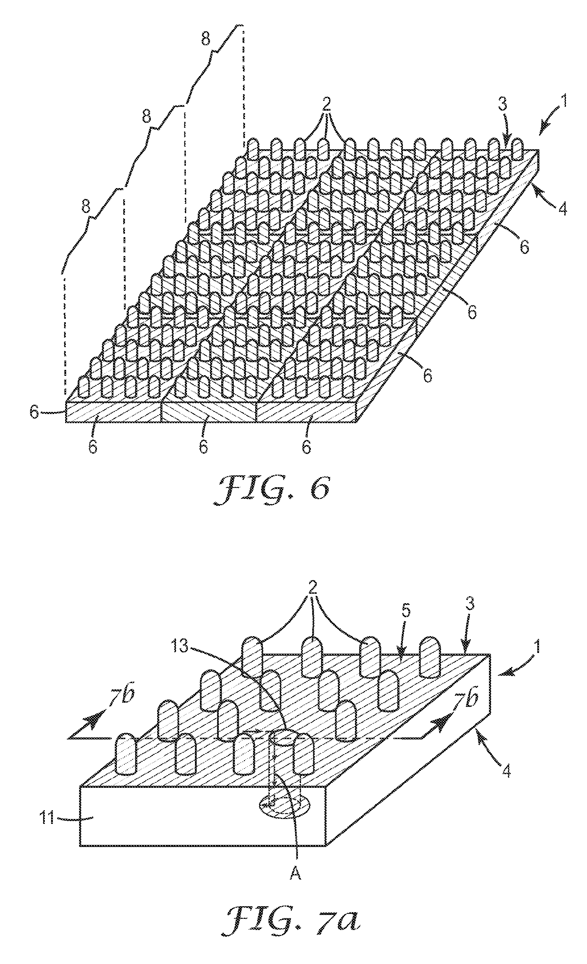

Fig. 3 shows a three dimensional schematic view of a first part 1 of a one row connector. The first part 1 comprises a mechanical reclosable fastener component 11 with a first side 3 and a second side 4. The first side 3 provides fastening elements 2. The first side 3 is partially coated with an electrically conductive material 5 thereby creating individual conductive areas 8. It also provides non conductive areas 7 between the conductive areas 8. The non conductive areas 7 may not comprise fastening elements 2 and/or they are not coated with electrically conductive material 5. The one row connector shown in fig. 3 provides three conductive areas 8 in a row and two non conductive areas 7. The edges adjacent to each conductive area 8 are coated with electrically conductive material 5 as well. These coated edges 6 each establish a conductive path for each individual conductive area 8 that electrically connects the first side 3 with the fastening elements 2 with the second side 4. Another possibility for creating insulation zones or non conductive areas 7 is to have a mechanical reclosable fastener component 11 with fastening elements 2 equally disposed on one side. Individual conductive areas 8 can be created by selectively coating the mechanical reclosable fastener component 11. Instead of the coated edges 6 it is also possible to have coated holes 13 (Fig. 7a) or micro vias in the fastener component.

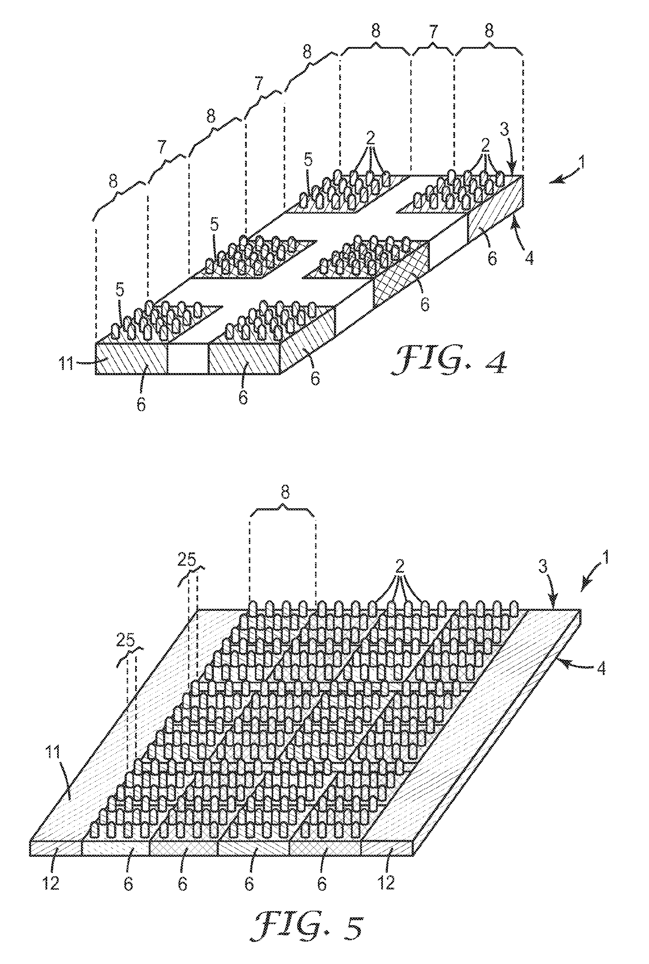

Fig. 4 shows a three dimensional schematic view of a first part 1 of a two row connector. The first part 1 comprises a mechanical reclosable fastener component 11 with a first side 3 and a second side 4. The first side 3 provides fastening elements 2. The first side 3 is partially coated with an electrically conductive material 5 thereby creating individual conductive areas 8. It also provides non conductive areas 7 between the conductive areas 8. The non conductive areas 7 may not comprise fastening elements and/or they are not coated with electrically conductive material 5. The two row connector shown in fig. 4 provides six conductive areas 8 in two rows, each row with three conductive areas. The edges adjacent to each conductive area 8 are coated with electrically conductive material 5 as well. These coated edges 6 each establish a conductive path for each individual conductive area 8 that electrically connects the first side 3 with the second side 4 from the first part 1 of the mechanical reclosable fastener component 11. Instead of the coated edges 6 it is also possible to have coated holes 13 or micro vias in the fastener component.

Fig. 5 shows a three dimensional schematic view of a first part 1 of a multiple two row connector. The first part 1 comprises several mechanical reclosable fastener components in the form of a two row connector as described in connection with fig. 4 with a first side 3 and a second side 4. The first side 3 provides fastening elements 2. The first side 3 is partially coated with an electrically conductive material thereby creating individual conductive areas 8. The conductive areas 8 may be coated with different kind of electrically conductive materials, such as for example gold, tin etc. They may also all be plated with the same material. The row connector shown in fig. 5 provides twenty-four conductive areas 8 in three two row packages. The different hatchings in fig. 5 indicate that each conductive area 8 may transmit a different signal. It also provides non conductive areas 25 between all conductive areas 8 (not shown in fig. 5). The non conductive areas 25 between the two row packages are openings between adjacent two row packages. The three two row packages are only connected with each other over an insulating part 12. Therefore all conductive areas 8 have their individual coated edge 6 at the edge of the two row package and the same principle of using the coated edges 6 as conductive path from the top to the bottom as described before can be used. The matrix of the connector itself is made of plastic coated with electrically conductive material and is framed by insulating parts 12 that may also have the shape of a mechanical reclosable fastener e.g. that may also provide fastening elements (not shown in fig. 5). It is possible to have at the beginning one piece of plastic, that is partially coated and then the openings are inserted. But it is also possible to assemble the matrix out of several modules. Instead of the coated edges 6 it is also possible to have coated holes 13 or micro vias (as shown in fig. 7a) in the fastener component as well.

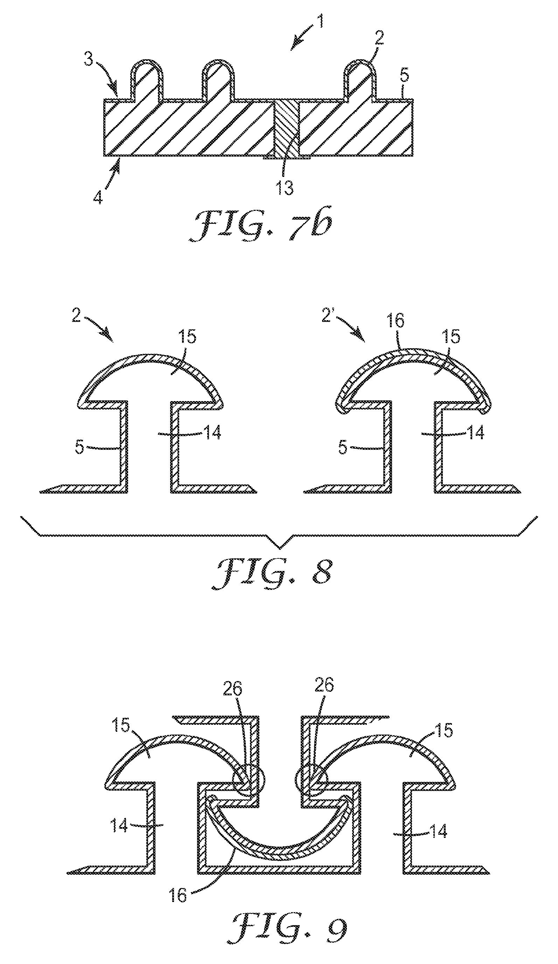

Fig. 6 shows a three dimensional view of a first part 1 of a matrix connector. The first part 1 comprises a mechanical reclosable fastener component 11 with a first side 3 and a second side 4. The first side 3 provides fastening elements 2. The first side 3 is partially coated with an electrically conductive material 5 thereby creating individual conductive areas 8. It also provides non conductive areas between the conductive areas 8 that cannot be seen in fig. 6. The edges adjacent to a conductive area 8 are coated with electrically conductive material 5 as well. These coated edges 6 establish a conductive path for the individual conductive area 8 to which it is adjacent. The conductive paths of the conductive areas 8 that are not located at an edge, such as the centre conductive area 8 in fig. 6, are provided by coated through holes that will be explained in connection with fig. 7.

Fig. 7a and 7b show a three dimensional view of a segment of a first part 1 of a connector as well as a sectional view of the same segment with a conductive path in the shape of a through hole 13 coated with electrically conductive material 5. Depending on its dimension the through hole 13 also can be a micro via. The first part 1 comprises a mechanical reclosable fastener component 11 with a first side 3 and a second side 4. The first side 3 provides fastening elements 2. The first side 3 is coated with an electrically conductive material 5. The through hole 13 is also coated with the electrically conductive material 5. The through hole 13 provides a conductive path from the first side 3 to the second side 4 of the connector and is an alternative to coated or plated edges as for example the coated edges 6 in figures 1 to 6. The edges of the first part 1 in fig. 7 may just be not plated or they may not exist because the connector extends beyond the shown part as it is the case with the matrix connector of fig. 6. The edges of the first part 1 in fig. 7 may just be not plated or they may not exist because the connector extends beyond the shown part as it is the case with the matrix connector of fig. 6. An electrical current or signal that is received from a coated fastening element 2 of the part 1 travels from the fastening element 2 to the coated bottom of the first side 3 and from there through the coated through hole 13 or micro via to the second side 4 as it is indicated by the arrows A.

Fig. 8 shows two fastening elements 2 and 2' of a mechanical reclosable fastener. The fastening elements 2 and 2' have the shape of a mushroom and comprise a stem or shank portion 14 and a head portion 15. The fastening elements 2 and 2' consist of insulating material and are coated with an electrically conductive material 5. The head portion 15 of the right fastening element 2 in fig. 8 is additionally coated with an electrically non conductive material 16. This non conductive coating only covers the tip or the head portion 15 of the fastening element 2'. If such coated or in other words isolated fastening elements 2' are pressed on fastening elements 2 with a conductive head portion 15 or non isolated fastening element 2 - so that they mate with each other as can be seen in fig. 9 - an electrical interface 26 is created on the fastening elements 2 and 2' between the heads 15 of the non isolated fastening elements 2 and the stems 14 of adjacent isolated fastening elements 2'. Through the heads 15 of the isolated fastening elements 2 no electric current can be transmitted. The purpose of the additional coating with non conductive material is to protect the fastening elements 2' from for example environmental influences. Prior to mate the interconnection system, a protection may be needed to avoid for example short circuits. Especially in a network a short circuit protection may be very important. Instead of additionally coating the heads 15 of fastening elements 2 it is also possible to remove the electrically conductive coating or to selectively coat the fastening elements 2 and 2' with electrically conductive coating, e.g. leave out the head portion.

The design of printed circuit boards can be very complex, especially when higher signal frequencies are involved. Modifications are time consuming, mostly limited and therefore very expensive. Due to the complexity of the multi-layer "all in one" design, sometimes modifications don't fit in the current design. A complete new design has to be done. Splitting the design into several sections or modules could solve most of the problems. The individual sections or modules will be attached to each other and will form the complete printed circuit board.

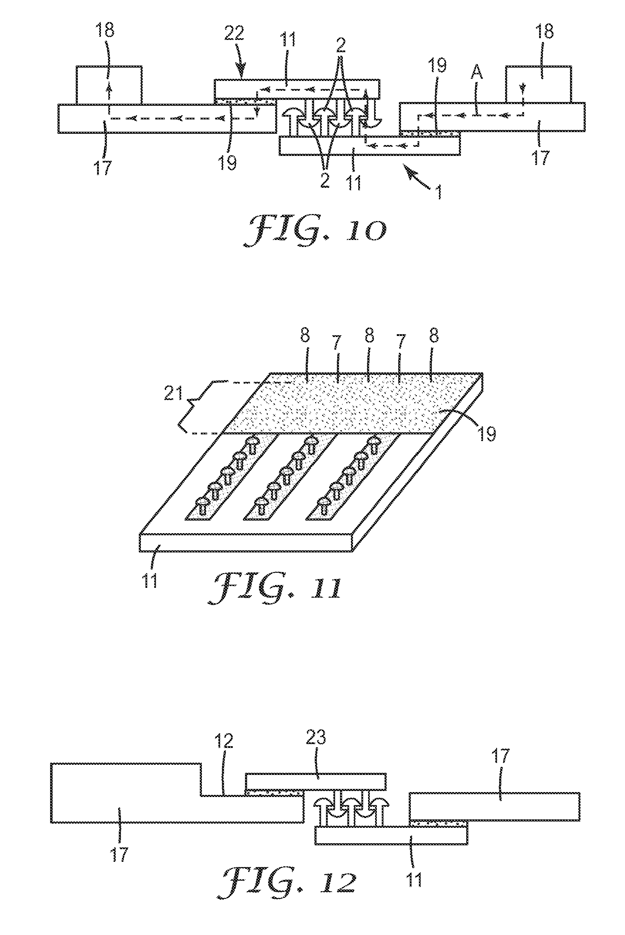

Fig. 10 shows two printed circuit boards 17 that are electrically and mechanically connected to each other by an arrangement according to the invention. The printed circuit boards 17 each comprise electronic components 18. The connection between the two printed circuit boards 17 is realized over two mechanical reclosable fastener components 11 - a first part 1 and a second part 22. The mechanical reclosable fastener components 11 are fixed at the top or bottom side of the printed circuit boards 17 with an electrically conductive adhesive 19 in a way that they each project over the edge of the printed circuit board 17 they are attached to. It is also possible to use fastening elements of a mechanical reclosable fastener for fixing the mechanical reclosable fastener component 11 to a printed circuit board. In that way a connection from the top to the bottom side and vice versa can be established. At the projecting part of the reclosable fastener components 11 fastening elements 2 are located. Fig. 10 shows the assembled arrangement of the two printed circuit boards 17 where the fastening elements 2 of the mechanical reclosable fastener components 11 mate with each other and establish the mechanical and the electrical connection. Fig. 11 shows how the electrical connection is established, e.g. it shows a mechanical reclosable fastener component 11 of fig. 10. The mechanical reclosable fastener components 11 provide conductive areas 8 and non conductive areas 7. The conductive areas 8 have the shape of a stripe. The components 11 comprise several parallel conductive stripes. The fastening elements 2 are located in the conductive areas 8 and provide a conductive surface as well. One possible way of producing such a component may be to make the mechanical reclosable fastener component 11 out of insulating material and than add the conductive areas 8 by selectively coating the component 11. As described before several other methods of producing such a component are possible as well. The mechanical reclosable fastener components 11 need to be arranged on the printed circuit boards 17 in a way that the parts of the conductive areas 8 that do not comprise any fastening elements 2 contact a signal path (not shown) on the printed circuit boards 17.

An electrical current or a signal that has to be transmitted from one printed circuit board 17 to the other will follow the path indicated by arrows A in fig. 10. Coming from the first printed circuit board 17 it enters the fastener component 11 at a transmitting point or transmitting area 21 (see fig. 11). The transmitting area 21 in this embodiment is the portion of the fastener component 11 that includes conductive area 8, which is attached to the printed circuit board 17 and is in connection with or contacts a contact of the printed circuit board 17. From there the signal flows along the stripe of the conductive area 8 to the fastening elements 2 where it leaves the first part 1 of the assembly or connector according to an aspect of the invention and enters the second part 22 of the connector. From the fastening elements 2 of the second part 22 the signal flows along the stripe of the conductive area 8 to the transmission area 21. At the transmission area it leaves the second part 22 and enters the second printed circuit board 17.

The embodiment shown in fig. 12 differs from that shown in fig. 10 in that the mechanical reclosable fastener component 11 is attached to an inner layer 23 of one of the printed circuit boards 17. With this embodiment an interconnection of an inner layer to another top or bottom or also an inner layer can be established.

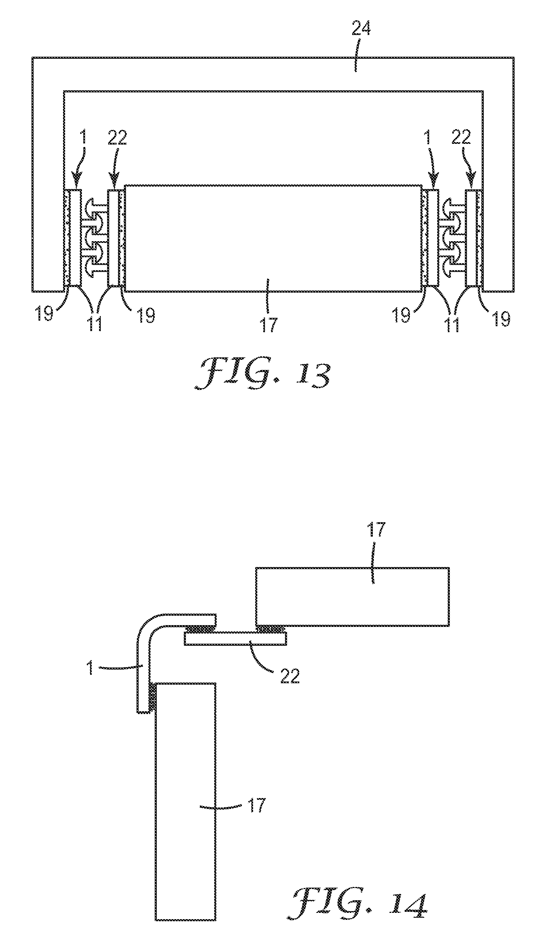

State of the art technology makes it possible to coat the edges of the printed circuit board with a conductive layer. This can be done for example for grounding reasons in order to improve the signal integrity of the whole system. Overall coated mechanical reclosable fastener components 11 can be attached to such edges of a printed circuit board 17 for example with electrical conductive adhesive 19 (see fig. 13). Thereby the printed circuit board 17 can be connected to a metallic frame or chassis 24.

If the mechanical reclosable fastener components 11 are made out of a flexible material it is also possible to arrange printed circuit boards 17 or modules of printed circuit boards within a certain angle. Having fastener elements on both sides of a mechanical reclosable fastener component makes it possible to use for example one side for the electrical interconnection and the other side for a mechanical connection. If the mechanical reclosable fastener component 11 or the second part of the arrangement according to the invention showed in fig. 10 would also have fastening elements on the bottom side the fastener component 11 and therewith the printed circuit board 17 could be locked to a housing or a chassis. Fig. 14 shows an embodiment of the invention where two printed circuit boards 17 are connected to each other over an arrangement according to an aspect of the invention. The base material of a first part 1 is made out of a flexible material. Therefore the connection between the printed circuit boards 17 can be realized with a certain angle.

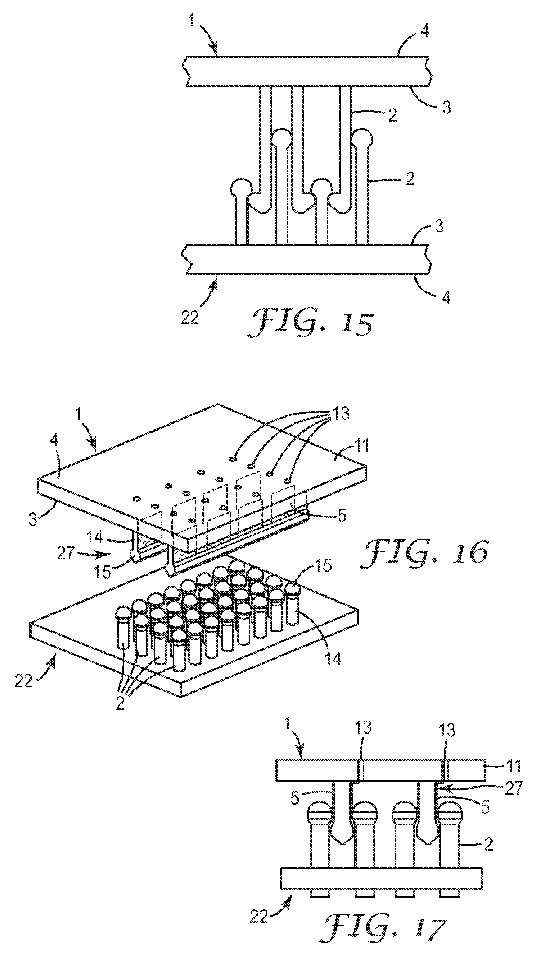

Fig. 15 is a schematic drawing of another embodiment according to one aspect of the assembly of the invention with one part that provides fastening elements 2 with two alternating heights. It can be seen a first part 1 of the arrangement with fastening elements 2 with two alternating heights and a second part 22 of the arrangement with fastening elements 2 with one height. Both parts 1 and 22 have first sides 3 and second sides 4. During the mating process of the assembly shown in fig. 15 the higher fastening elements 2 of the second part 22 will first mate with the fastening elements 2 of the first part 1. Secondly the lower fastening elements 2 of the second part 22 will mate with the fastening elements 2 of the first part 1. During the disconnection operation, first the lower fastening elements 2 of the second part 22 and then the higher fastening elements 2 will disconnect. The higher fastening elements may for example be used for the transmission of power or ground and the lower fastening elements may for example be used for the transmission of signals. For such an embodiment the fastening elements 2 may be partially coated at their side flanges as described in connection with the following figures. With such an assembly an early mate / late break principle that is know from existing electrical connectors can easily be realised by connectors comprising mechanical reclosable fasteners. During the disconnection operation first the signal will be disconnected before the power will be shut off or the ground will be disconnected. The early mate / late break principle makes it possible to mate and disconnect individual connectors without shutting down the complete system.

The alternating heights of fastening elements may also have a positive effect on the mating force of two mechanical reclosable fastener components. A mating force peak of mechanical reclosable fastener components is generated by an opening force and a friction force of all fastening elements that mate with each other. Having several heights of fastening elements will decrease the number of fastening elements mating at one time and therefore lower the initial insertion force.

Fig. 16 shows a three dimensional schematic drawing of an arrangement for electrically and mechanically connecting electronic components to each other with a first part 1 and a second part 22. The second part 22 is a mechanical reclosable fastener component 11 for example as described in reference to fig. 1 with a plurality of separate fastening elements 2 in the shape of a mushroom, each fixing element comprising a shank portion 14 and a head portion 15. The first part 1 is made from an extruded mechanical reclosable fastener component 11 with lines of fastening elements 27 each line having a shank portion 14 and a head portion 15. The fastening elements 27 with a stem portion 14 and a head portion 15 are made out of insulating material and partially coated with electrically conductive material 5. The coating of the electrically conductive material 5 is placed in areas where the fastening elements 2 of the mating second part 22 contact the lines of fastening elements 27. In the embodiment shown in fig. 16 this is in the shank portion 14 as indicated by the hatched areas that show the coated areas 5. The coated area 5 of the shank portion 14 all have the same size and are equally spaced apart. The conductive path is provided in the shape of coated holes 13 establishing an electrical connection between the first side 3 and the second side 4.

Fig. 17 shows a sectional view of the arrangement shown in fig. 16 in a connected stage. It can be seen the separate fastening elements 2 of the second part 22 as well as the line fastening elements 27 with the coated areas 5 and the coated holes 13.

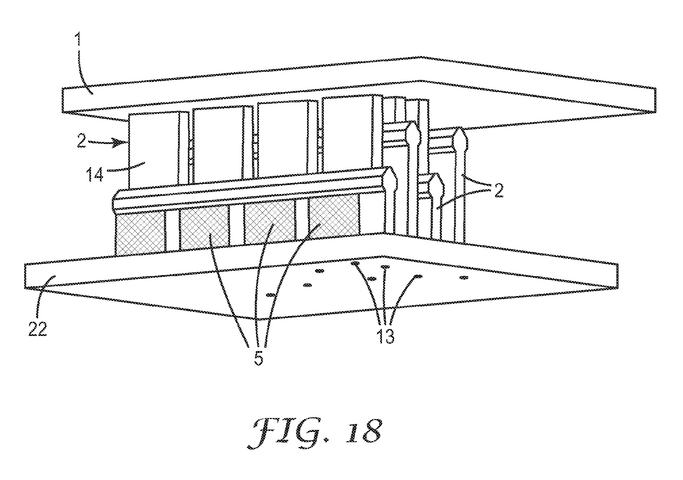

Fig. 18 shows a three dimensional drawing of another arrangement for electrically and mechanically connecting electronic components to each other. The first part 1 of the arrangement has fastening elements 2 that all have the same height. The fastening elements 2 have a shank portion 14 and a head portion (not shown in fig. 18). The fastening elements 2 have the shape of an extruded line as the fastening elements 2 of fig. 16 and 17 instead of spaced apart coated areas 5 these fastening elements 2 are spaced apart themselves, e.g. by cutting out parts after extruding the lines. The fastening elements 2 of the second part 22 have two different heights. They resemble to the fastening elements 2 shown in fig. 16 and 17 with coated areas 5. In fig. 18 also can be seen the through holes 13 providing a conductive path for the second part 22.

### REFERENCE SIGNS LIST

- 1: first part of the arrangement
- 2, 2': fastening element
- 3: first side
- 4: second side
- 5: electrically conductive material
- 6: coated edge
- 7: non conductive area
- 8: conductive area
- 9: printed circuit board
- 11: mechanical reclosable fastener component
- 12: insulating part
- 13: coated through hole
- 14: stem portion
- 15: head portion
- 16: non conductive material
- 17: printed circuit board
- 18: electronic component
- 19: electrically conductive adhesive
- 21: transmitting point
- 22: second part
- 23: inner layer of printed circuit board
- 24: frame/chassis
- 25: non conductive area
- 26: electrical interface
- 27: fastening element

- A: path of an electrical current

## Claims

1. An arrangement for electrically and mechanically connecting electronic components to each other comprising
- a first part (1) and
- a second part (22),
- the two parts each comprise a mechanical reclosable fastener component (11) configured to mate with the mechanical reclosable fastener component (11) of the other part,
- the fastener components (11) are having a first side (3) providing fastening elements (2) for making a mechanical connection and a second side (4), wherein
- the first side (3) of the fastener components (11) provides a surface that is made out of an electrically conductive material (5) for making an electrical connection and wherein
- a conductive path (6, 13) is provided that electrically connects the first side (3) with the second side (4) of the reclosable fastener components (11).

2. The arrangement according to claim 1, wherein the mechanical reclosable fastener components (11) of the two parts (1, 22) have the same geometrical shape.

3. The arrangement according to claim 1 or 2, wherein the fastening elements (2) of the mechanical reclosable fastener components (11) have a mushroom shaped stem with a shank portion (14) and a head portion (15).

4. The arrangement according to any of the preceding claims, wherein the first sides (3) of the mechanical reclosable fastener components (11) provide conductive areas (8) and non conductive areas (7).

5. The arrangement according to any of the preceding claims, wherein the mechanical reclosable fastener components (11) are made out of an insulating material and at least partially coated with an electrically conductive material (5).

6. The arrangement according to claims 1 to 4, wherein at least one part comprises a mechanical reclosable fastener component (11) made out of electrically conductive material.

7. The arrangement according to claim 4, wherein the non conductive areas (7) are not coated with electrically conductive material (5).

8. The arrangement according to claim 4, wherein the non conductive areas (7) are flat areas without fastening elements (2).

9. The arrangement according to any of the claims 1 to 5 and 7 and 8, wherein the mechanical reclosable fastener components (11) provide edges (6) and/or holes (13) coated with electrically conductive material (5) as conductive paths.

10. The arrangement according to any of the preceding claims, wherein at least some head portions (15) of the fastening elements (2) of at least one part (1, 22) are non conductive.

11. The arrangement according to claim 8, wherein at least some head portions (15) of at least one part (1, 22) are coated with insulating material.

12. The arrangement according to any of the preceding claims, wherein the second side (4) of the mechanical reclosable fastener component (11) provides fastening elements (2) as well.

13. An arrangement for electrically and mechanically connecting electronic components to each other comprising
- a first part (1) and
- a second part (22),
- the two parts (1, 22) each comprise a mechanical reclosable fastener component (11) configured to mate with the mechanical reclosable fastener component (11) of the other part,
- the fastener components (11) are providing fastening elements (2) for making a mechanical connection, wherein
- the fastening elements (2) provide a surface that is at least made out of an electrically conductive material (5) for making an electrical connection and wherein
- a conductive path is provided that electrically connects the coated fastening elements (2) with a transmitting point (21).

14. The arrangement according to claim 11, wherein the first (1) and/or the second part (22) of the arrangement is/are attached to a top side, a bottom side and/or an inner layer (23) of a printed circuit board (17) or a printed circuit board module.

15. The arrangement according to claim 11 or 12, wherein the first (1) and/or the second part (22) of the arrangement is/are attached by conductive adhesive, solder, welding and/or ultrasonic welding to the printed circuit board (17).
